# EUROPEAN PATENT APPLICATION

(11) **EP 3 499 580 A1**
(43) Date of publication of application: **19.06.2019**
(21) Application number: 17208150.7
(22) Date of filing: 18.12.2017
(51) Int. Cl.: H01L 29/66, H01L 29/788, H01L 29/792, H01L 27/11551, H01L 27/1157, H01L 27/11578

(54) **METHOD OF MANUFACTURING A 3D SEMICONDUCTOR MEMORY DEVICE AND DEVICE MANUFACTURED USING SUCH METHOD**

(71) Applicant: IMEC vzw, 3001 Leuven (BE)
(72) Inventor: LAVIZZARI, Simone, 3001 Leuven (BE)
(74) Representative: AWA Sweden AB

(57) **Abstract**

According to an aspect of the present inventive concept there is provided a method of manufacturing a three-dimensional, 3D, semiconductor memory device comprising a plurality of bit cells, each of which comprising a control gate, a memory element and a channel, wherein the method comprises: providing a vertical stack of alternating layers of a first layer type and a second layer type over a substrate; forming a memory opening through the vertical stack; forming a memory material layer on a sidewall of the memory opening, wherein the memory material layer forms the memory element of each of the plurality of bit cells; forming the channel in the memory opening; forming a further opening through the vertical stack, offset from the memory opening; recessing, from the further opening, the first layer type to form first recesses extending to the memory material layer; extending each of the first recessed by, from the further opening and through each of the first recesses, etching through the memory material layer; and filling each of the first recesses with an insulating material.

## Description

### Technical field

The present inventive concept relates to the field of semiconductor devices. In particular, it relates to methods of manufacturing a 3D semiconductor memory device such as a 3D NAND or 3D FeFET memory.

### Background

More highly integrated semiconductor devices are required to satisfy consumer demands for electronic products that offer superior performance and yet are relatively inexpensive. This is especially true of semiconductor memory devices. In the case of a typical two-dimensional or planar semiconductor memory device, the integration (density) of the device mainly corresponds to the area occupied by a unit memory cell of the device. For larger memories, or smaller devices, this may be a problem, and may result in an unsatisfying integration. To overcome such a drawback, three-dimensional semiconductor memory devices having three-dimensionally (3D) arranged memory cells have been recently proposed. However, in fabrication of 3D semiconductor memory devices, various problems may occur due to structural configurations thereof. Consequently, one disadvantage of 3D semiconductor memory compared to planar (2D) semiconductor memory is that the manufacturing cost often is higher. A simpler manufacturing process for 3D semiconductor memories would thus be advantageous.

### Summary

An objective of the present inventive concept is to achieve a simplified manufacturing process of 3D semiconductor memory devices.

According to an aspect of the present inventive concept there is provided a method of manufacturing a three-dimensional, 3D, semiconductor device comprising a plurality of bit cells, each of which comprising a control gate, a memory element and a channel, wherein the method comprises:
- providing a vertical stack of alternating layers of a first layer type and a second layer type over a substrate;
- forming a memory opening through the vertical stack;
- forming a memory material layer on a sidewall of the memory opening, wherein the memory material layer forms the memory element of each of the plurality of bit cells;
- forming the channel in the memory opening;
- forming a further opening through the vertical stack, offset from the memory opening;
- recessing, from the further opening, the first layer type to form first recesses extending to the memory material layer;
- extending each of the first recessed by, from the further opening and through each of the first recesses, etching through the memory material layer; and
- filling each of the first recesses with an insulating material.

As used herein, a "layer" refers to a material portion including a region having a thickness. A layer may extend over the entirety of an underlying or overlying structure, or may have an extent less than the extent of an underlying or overlying structure. Further, a layer may be a region of a homogeneous or inhomogeneous continuous structure that has a thickness less than the thickness of the continuous structure. For example, a layer may be located between any pair of horizontal planes between, or at, a top surface and a bottom surface of the continuous structure. A layer may extend horizontally, vertically, and/or along a tapered surface. A substrate may be a layer, may include one or more layers therein, and/or may have one or more layer thereupon, thereabove, and/or therebelow.

The vertical stack of alternating layers of a first layer type and a second layer type may according to embodiments be considered as placeholders for structures of the 3D semiconductor memory. Such placeholding layers may also be called sacrificial layers, since they are intended to be removed during the manufacturing process.

By the term "recessing" should, in the context of the present specification, be understood making a concavity in the vertical stack of alternating layers, for example by removing parts of a layer of the first layer type while leaving adjacent layers of the second layer type intact. Recessing may for example be done by an etching process.

The proposed integration scheme allows having a single process that can be used to form a 3D semiconductor memory device comprising a plurality of bit cells. By providing a further opening in the vertical stack of alternating layers, from which the layers of the first layer type are recessed to form first recesses, and from which opening the recesses thereafter are extended by also removing the memory material layer, the manufacturing process are simplified. For example, the double recessing procedure (forming and extending the first recesses) allows for a floating-gate type flash memory in a simpler integration rather than realizing it via the memory opening which is typically very small, and the sequent recess of the floating gate layer (i.e. memory material layer) from the memory opening is very complex. Moreover, since the memory opening is not used for such recessing/removing procedure, the memory material layer and the semiconductor channel may be provided into the memory opening in a straightforward matter, and e.g. the slicing of the memory material layer (etching of the memory material layer between the layers of the second material type) to separate the memory elements of the bit cells from each other, can be performed from the further opening instead. An advantageous integration scheme for implementing e.g. a floating metal layer (in the case of a 3D NAND memory) or a metal layer (in case of 3D FeFET memory) may thus be achieved. For example, for FeFET (ferroelectric memory layer), the present integration scheme allows for thermal treatment of the channel (which is typically very high, >900C), without risking losing the ferroelectricity of the ferroelectric memory material layer.

According to some embodiments, the method further comprises
- recessing, from the further opening, the second layer type to form second recesses extending to the memory material layer; and
- filling each of the second recesses with a control gate material to form the control gate of each of the plurality of bit cells.

In this embodiment, also the second material layer is recessed (removed, etched, etc.) from the further opening, which further simplifies the manufacturing process. The control gate material is then provided into the second recesses.

According to some embodiments, the method further comprises, prior to filling each of the second recesses with a control gate material, lining each second recess with an oxide material. The lining may be performed using atomic layer deposition (ALD). Consequently, leakage of stored electrical charges in the memory material to control gate electrodes may be blocked. Moreover, the integration scheme according to the present embodiment allows for the realization of the MFMIS (Metal-Ferro-Metal-Insulator-Silicon) type of memory.

According to some embodiments, the method further comprising the step of providing an insulating layer (may also be called a tunneling layer in the context of floating-gate type flash memory) between the memory material layer and the channel. Consequently, an insulating buffer layer is inserted between the channel and the memory material. The storage of electrons in the memory element may thus be improved. For example, in case the memory element is a ferroelectric material, serious inter diffusion near the interface between the ferroelectric material and a silicon or polysilicon channel may occur. Also, Nitride (another exemplary memory material) may be prone to lateral charge migration. An insulating buffer layer can thus advantageously be inserted between the channel and memory material layer.

According to some embodiments, the step of forming a memory material layer on a sidewall of the memory opening comprises using a ferroelectric material layer as the memory material layer. This type of memory material may reduce power consumption of the 3D memory device, and increase switching speed, scalability and retention of the 3D memory device.

According to some embodiments, the step of forming a memory material layer on a sidewall of the memory opening comprises using a charge trapping layer as the memory material layer. For example, the charge trapping layer may be formed by a nitride material or a high-k material such as gadolinium oxide.

According to some embodiments, the step of forming a memory material layer on a sidewall of the memory opening comprises using a doped polycrystalline silicon layer as the memory material layer.

According to a second aspect of the present inventive concept, there is provided a 3D semiconductor memory device formed by any of the embodiments of the first aspect.

According to a third aspect of the present inventive concept, there is provided a 3D FeFET memory device formed by any of the embodiments of the first aspect, wherein the memory material layer is a ferroelectric material layer.

According to a fourth aspect of the present inventive concept, there is provided a 3D charge trapping NAND memory device formed by any of the embodiments of the first aspect, wherein the memory material layer is a charge trapping layer.

According to a fifth aspect of the present inventive concept, there is provided a 3D floating gate NAND memory formed by any of the embodiments of the first aspect, wherein the memory material layer is a doped polycrystalline silicon layer. In this embodiment, the memory material layer is typically called the floating gate layer.

This second, third, fourth and fifth aspect may generally present the same or corresponding advantages as the first aspect.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise. As illustrated in the figures, the sizes of layers and regions are exaggerated for illustrative purposes and, thus, are provided to illustrate the general structures of embodiments of the present invention.
Figs. 1-9 each show, in cross section, different parts of a method of manufacturing a three-dimensional, 3D, semiconductor memory device according to embodiments,
Fig. 10 shows a method of manufacturing a 3D semiconductor memory device according to embodiments.

### Detailed description

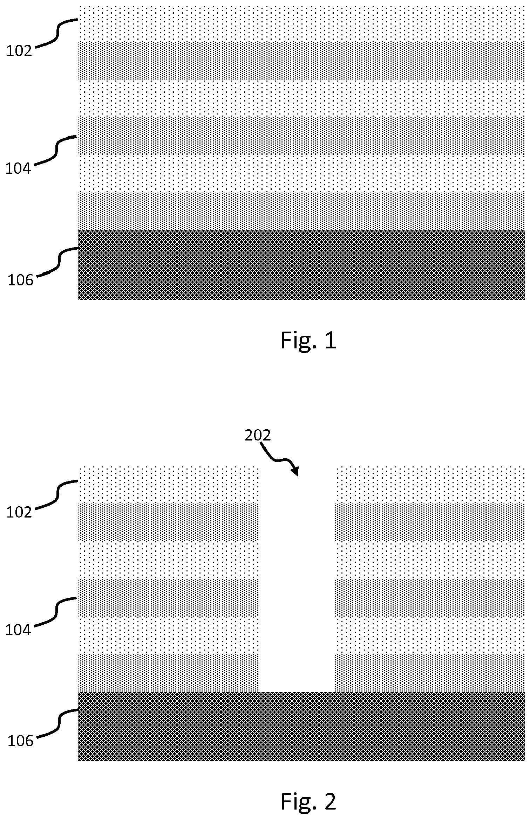

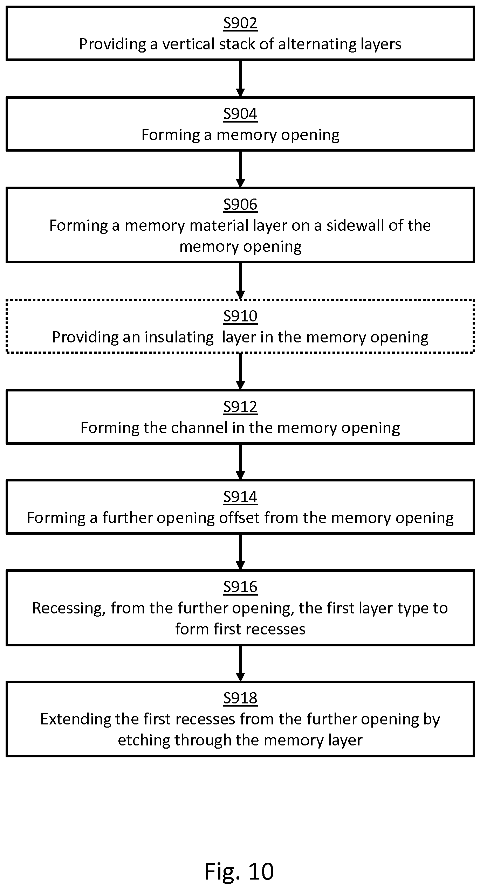

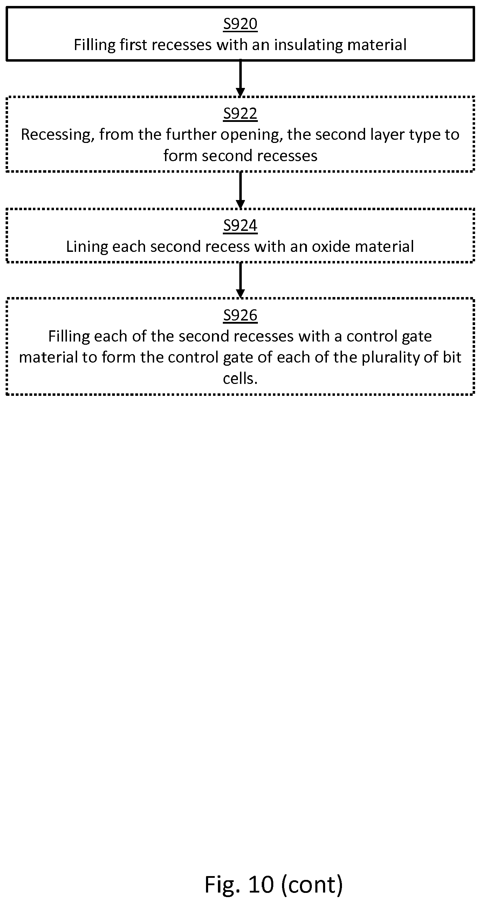

Embodiments of a manufacturing process of a 3D semiconductor memory device will now be described using figures 1-9 in conjunction with the method flow chart of figure 10.

Fig. 1 illustrates a first part of a method of manufacturing a three-dimensional, 3D, semiconductor memory device comprising a plurality of bit cells, each of which comprising a control gate, a memory element and a channel. In figure 1, a vertical stack of alternating layers of a first layer type 104 and a second layer type 102 is provided S902 over a substrate 106. According to some embodiment, the first 104 and second 102 layer types are sacrificial layers, meaning that both layer types will be removed in the process of manufacturing the 3D memory. According to some embodiments, the second layer type 102 consist of a control gate material, possibly with an insulating layer at least partly surrounding it. The material for the first and second layer type may be any suitable material such that the layers 102, 104 can be removed selective to each other, i.e. such that only the first layer 104 is removed, and not the second layer 102, or vice versa, e.g. using an etching process. The material of the layers 102, 104 may be a Nitride material and a Polycrystalline material such as Polycrystalline silicon. According to some embodiments, circuitry under the vertical stack of alternating layers 102, 104 is provided.

Fig. 2 illustrates a second part of a method of manufacturing the 3D semiconductor memory device according to embodiments. In figure 2, a memory opening 202 is formed S904 through the vertical stack. The memory opening 202 is an opening in which the memory elements of the bit cells of the 3D memory will be provided. The memory opening 202 may be provided by etching portions of the alternating stack, 102, 104. In figures 1-8, only one memory opening 202 is formed, but it should be noted according to embodiment, a plurality of such openings is formed in the vertical stack of alternating layers 102, 104. According to some embodiment, the memory opening 202 is extending partly into the substrate. This may provide an anchoring effect for the channel, memory elements and/or insulating layers which later will be provided into the memory opening 202,

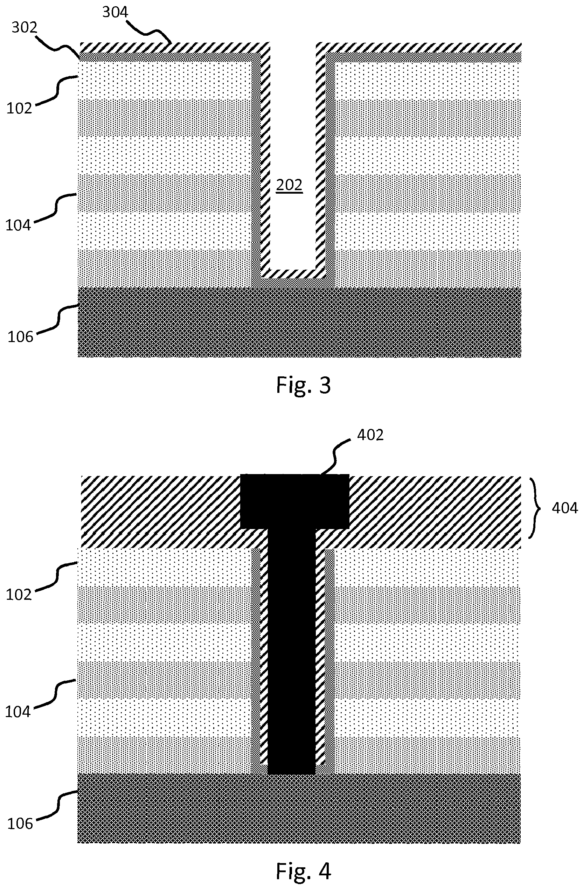

Fig. 3 illustrates a third part of a method of manufacturing the 3D semiconductor memory device according to embodiments. In figure 3, a memory material layer 302 is formed S906 on a sidewall of the memory opening 202. Parts of the memory material layer 302 will form the memory element of each of the plurality of bit cells when the 3D memory is complete. The material of the memory material layer may differ based on what type of 3D memory that is manufactured. For example, in the case a 3D charge trapping NAND memory device is manufactured, a charge trapping layer (such as a nitride layer) may be used as the memory material layer 302. In the case a 3D FeFET memory device is manufactured, a ferroelectric material layer (such as a Hafnium dioxide, HFO2, layer) may be used as the memory material layer 302. In the case a 3D Floating gate NAND memory device is manufactured, a doped polycrystalline silicon layer may be used as the memory material layer 302. The memory material layer 302 may be formed on the sidewall of the memory opening 202 using a Chemical Vapor Deposition (CVD) process, such as Atomic Layer Deposition (ALD). For simplicity of providing the memory material layer 302, the memory material layer 302 may be formed also on top of the upper layer in the stack of alternating layers 102, 104.

Optionally, the insulating layer 304 may be formed S910 on top of the memory material layer 302, e.g. using a CVD/ALD process. This step may be particularly advantageous e.g. in the case of manufacturing a 3D FeFET memory device, where the insulating layer 304 may reduce the interdiffusion effect between the ferroelectric material of the memory material layer 302 and the later provided channel. The material of the insulating layer 304 may for example be an oxide material. Further possible insulating materials will be described below.

Fig. 4 illustrates a fourth part of a method of manufacturing the 3D semiconductor memory device according to embodiments. In figure 4, a channel 402 is formed 912. The channel 402 will form the channel of each of the plurality of bit cells of the 3D semiconductor memory device that is manufactured. In figure 4, the channel 402 has the shape of a plug (filling the remaining of the memory opening 202), but in some embodiment, the channel has the shape of a pipe (also known as a macaroni shape), i.e. being a layer abutting the memory material layer 302 or the insulating layer 304. Such shape may improve electrostatic channel control of the 3D memory device. In the case of the pipe shaped channel, the remaining parts of the memory opening 202 will be filled by a filling material. The plug shaped channel 402 may have an upper part ("head") of a different radius than the remaining of the plug, for stability reasons. Further, an insulating layer 404 may be provided around the upper part of the plug to prepare for planarizing the top part for subsequent processing steps of the 3D memory device. In summary, figure 3 and 4 discloses forming a lateral memory stack structure in the memory opening 202 comprising, from outside to inside, a memory material layer 302, optionally an insulating layer 304 and a semiconductor channel 402;

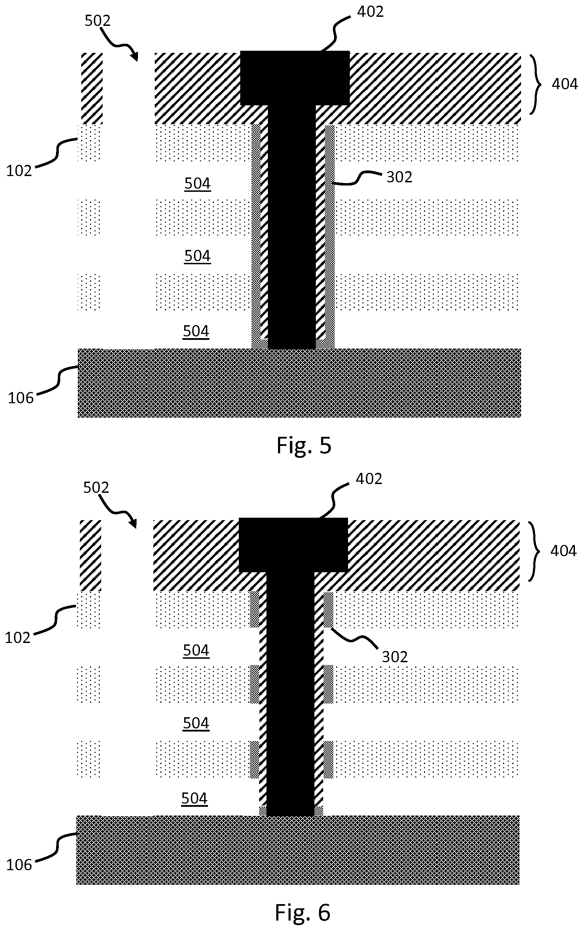

Fig. 5 illustrates a fifth part of a method of manufacturing the 3D semiconductor memory device according to embodiments. In figure 5, a further opening 502 is formed S914 through the vertical stack of alternating layers 102, 104. The further opening is extending to the substrate 106. The further opening 502 is formed offset from the memory opening 202, such that the further opening 502 will not remove the layers already provided in the memory opening. The further opening 502 may be formed in a similar way as the memory opening 202, i.e. using different etching procedures. The further opening 502 may have any suitable shape, for example a slit shape, or a circular/rectangular shape.

After the further opening is formed, first recesses 504 is formed S916 from the further opening, by recessing the first layer type 104. The first recesses 504 extend to the memory layer 302. The recessing may be done using a suitable etching process for etching the material of the first layer type 104.

Fig. 6 illustrates a sixth part of a method of manufacturing the 3D semiconductor memory device according to embodiments. In figure 6, each of the first recesses 504 are extended S918 by, from the further opening 502 and through each of the first recesses 504, etching through the memory material layer 302. The first recesses 504 are thus extended to reach to the insulating layer 304 provided earlier (as described in figure 3) between the memory material layer 302 and the channel 402. In case no such insulating layer 304 has been provided, the first recesses will instead be extended to reach the channel 402. As a consequence of the extension of the first recesses 504, the memory material layer 302 are sliced in smaller parts. Each smaller part will form the memory element for a bit cell of the plurality of bit cells of the 3D memory device. The etching process may remove a slice of the memory material layer 302 with a height of the first recess 504 through which the etching process is conducted. According to some embodiment, a smaller part of the memory material layer 302 abutting the second material layer 102 is also removed, leaving a first recess 504 with a slightly larger size at an end part of the first recess 504.

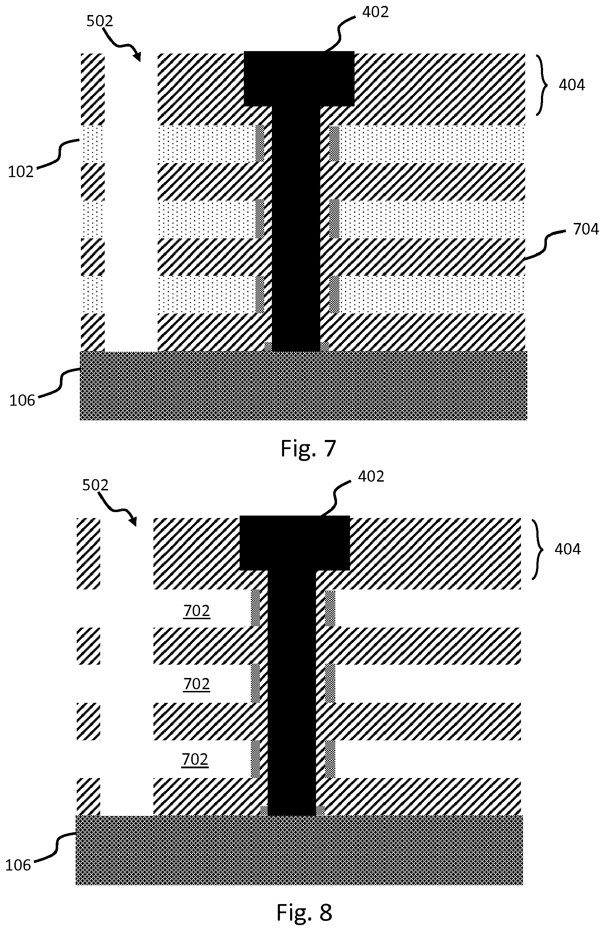

Fig. 7 illustrates a seventh part of a method of manufacturing the 3D semiconductor memory device according to embodiments. In figure 7, each of the first recesses 514 are filled S920 with an insulating material 704. In the figures 1-9. The insulating material 704 provided in the first recesses, the insulating layer 304 provided between the memory material layer 302 and the channel 402, and the insulating material 404 provided on around the upper part of the plugged shaped channel 402 (on top of the upper layer of the vertical stack of alternating layers) are illustrated as being the same material. However, this is just by way of example. The materials may also differ. The insulating material may be an oxide, for example silicon oxide. Further suitable materials may include silicon nitride, silicon oxynitride, organosilicate glass (OSG) and spin-on dielectric materials.

Fig. 8 illustrates an eight part of a method of manufacturing the 3D semiconductor memory device according to embodiments. In figure 8, second recesses 702 are formed S922 by, recessing, from the further opening 502, the second layer type 102. The recessing may be done using a suitable etching process for etching the material of the second layer type 102.

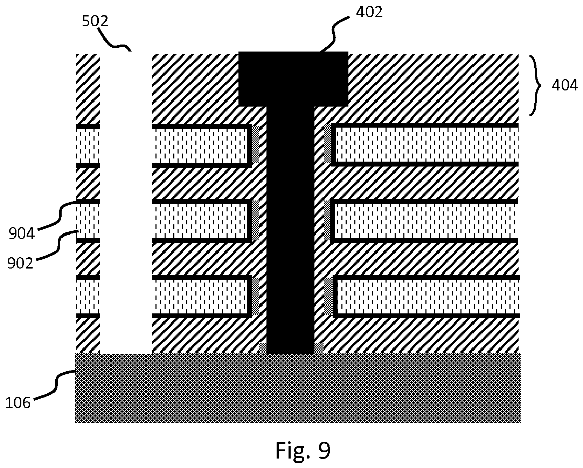

Fig. 9 illustrates a ninth part of a method of manufacturing the 3D semiconductor memory device according to embodiments. In figure 9, each of the second recesses 702 are filled S926 with a control gate material 902 to form the control gate of each of the plurality of bit cells of the 3D semiconductor memory device. Prior to filling the second recesses 702 with the control gate material, in some embodiments, each second recess 702 is lined S924 with an oxide material 904, to form an insulating layer between the control gate material 902 and the memory material layer 302 (i.e. the memory element) for each bit cell. Consequently, leakage of stored electrical charges in the memory material to control gate electrodes may be blocked. Examples of the insulating layer 904 includes aluminum oxide as well as more complex structures such as aluminum oxide or silicon oxide or silicon oxide followed by aluminum oxide or silicon oxide followed by hafnium oxide or silicon oxide followed by zirconium oxide. Typically, when silicon oxide is included in the insulating layer 904, the high-k liner material is used to decouple the silicon oxide from the metal control gate 902 to prevent fermi-level pinning and allow for the correct engineering of the work function between the metal control gate 902 and the silicon oxide.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method of manufacturing a three-dimensional, 3D, semiconductor memory device comprising a plurality of bit cells, each of which comprising a control gate, a memory element and a channel, wherein the method comprises:
providing (S902) a vertical stack of alternating layers of a first layer type (104) and a second layer type (102) over a substrate (106);
forming (S904) a memory opening (202) through the vertical stack;
forming (S906) a memory material layer (302) on a sidewall of the memory opening, wherein the memory material layer forms the memory element of each of the plurality of bit cells;
forming (S912) the channel (402) in the memory opening;
forming (S914) a further opening (502) through the vertical stack, offset from the memory opening;
recessing (S916), from the further opening, the first layer type to form first recesses (504) extending to the memory material layer;
extending (S918) each of the first recessed by, from the further opening and through each of the first recesses, etching through the memory material layer; and
filling (S920) each of the first recesses with an insulating material (702).

2. The method of claim 1, further comprising
recessing (S922), from the further opening, the second layer type to form second recesses (702) extending to the memory material layer; and
filling (S926) each of the second recesses with a control gate material (902) to form the control gate of each of the plurality of bit cells.

3. The method of claim 2, further comprising, prior to filling each of the second recesses with a control gate material, lining (S924) each second recess with an oxide material (904).

4. The method of any one of claims 1-3, further comprising the step of providing (S910) an insulating layer (304) between the memory material layer and the channel.

5. The method of any one of claims 1-4, wherein the step of forming a memory material layer on a sidewall of the memory opening comprises using a ferroelectric material layer as the memory material layer.

6. The method of any one of claims 1-4, wherein the step of forming a memory material layer on a sidewall of the memory opening comprises using a charge trapping layer as the memory material layer.

7. The method of claim 6, wherein the charge trapping layer is formed by a nitride material or a high-k material such as gadolinium oxide.

8. The method of any one of claims 1-4, wherein the step of forming a memory material layer on a sidewall of the memory opening comprises using a doped polycrystalline silicon layer as the memory material layer.

9. A 3D semiconductor memory device formed by the method of any one of claims 1-8.

10. A 3D FeFET memory device formed by the method of claim 5.

11. A 3D charge trapping NAND memory device formed by the method of any one of claims 6-7.

12. A 3D floating gate NAND memory device formed by the method of claim 8.
